(19) **Europäisches Patentamt**
**European Patent Office**
**Office européen des brevets**

(11) **EP 4 769 872 A1**

(12) **EUROPEAN PATENT APPLICATION**
published in accordance with Art. 153(4) EPC

(43) Date of publication:
01.07.2026 Bulletin 2026/27

(21) Application number: 24856510.3

(22) Date of filing: 22.08.2024

(51) International Patent Classification (IPC):
$H02J\ 7/00^{(2026.01)}$        $G01R\ 31/00^{(2006.01)}$
$G01R\ 31/382^{(2019.01)}$        $G01R\ 31/385^{(2019.01)}$
$G01R\ 31/389^{(2019.01)}$        $G01R\ 31/392^{(2019.01)}$
$H01M\ 10/48^{(2006.01)}$

(52) Cooperative Patent Classification (CPC):
G01R 31/00; G01R 31/382; G01R 31/385;
G01R 31/389; G01R 31/392; H01M 10/48;
H02J 7/00; Y02E 60/10

(86) International application number:
PCT/JP2024/029792

(87) International publication number:
WO 2025/041822 (27.02.2025 Gazette 2025/09)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 22.08.2023 JP 2023134796

(71) Applicant: **Daiwa Can Company**
**Chiyoda-ku, Tokyo 100-7009 (JP)**

(72) Inventors:
• **ARIMA, Masahito**
 **Sagamihara-shi, Kanagawa 252-5183 (JP)**
• **LIN, Lei**
 **Sagamihara-shi, Kanagawa 252-5183 (JP)**
• **ONIKI, Naoki**
 **Sagamihara-shi, Kanagawa 252-5183 (JP)**

(74) Representative: **AWA Sweden AB**
**Box 5117**
**200 71 Malmö (SE)**

(54) **DETERIORATION STATE ESTIMATION DEVICE FOR POWER STORAGE SYSTEM, DETERIORATION STATE ESTIMATION METHOD, AND POWER STORAGE SYSTEM OPERATION OPTIMIZATION METHOD**

(57)     A degradation state estimation apparatus estimates a degradation state of a battery energy storage system including a secondary battery and a DC-AC converter. The apparatus includes an estimation arithmetic processing unit (27) that estimates an open circuit voltage ($V_{oc}$) and an internal resistance (R) with respect to a charging rate of the secondary battery based on a charge-discharge voltage ($V_{c,d}$) and a charge-discharge current (I) of the secondary battery, and input-output power of the DC-AC converter, estimates efficiency ($\eta_{pcs}$) of the DC-AC converter and power consumption ($E_{au,I}$) of an auxiliary device of the DC-AC converter, and estimates charge-discharge energy efficiency (RTE) with respect to the charging rate of the secondary battery and a rated input-output ratio on an AC side of the DC-AC converter based on the estimated open circuit voltage, the internal resistance, the efficiency of the DC-AC converter, and the power consumption of the auxiliary device of the DC-AC converter.

F I G. 8

## Description

FIELD

The present invention relates to a degradation state estimation apparatus of a battery energy storage system for estimating a degradation state of the battery energy storage system including a secondary battery and a DC-AC converter, a degradation state estimation method, and a battery energy storage system operation optimization method.

BACKGROUND

In recent years, a battery energy storage system (BESS) has been expected as a power temporary storage device for countermeasures against output fluctuation and time shift of variable renewable energy (VRE), and a lithium ion battery (LIB) having particularly excellent energy density and output density has attracted attention as a rechargeable battery, that is, a secondary battery thereof.

LIBs have problems in terms of cost and resources (cobalt, nickel, lithium, copper, and the like), and in order to solve the problems, efforts have been made for reusing LIBs that have reached end of life as in-vehicle LIBs that are required to have high performance, as stationary BESS that is operated relatively gently. On the other hand, there is a phenomenon called degradation in which performance of the LIB deteriorates over time, and in reuse, it is required to perform a degradation diagnosis in order to perform classification based on application determination and residual performance at a start of the reuse and grasp a state during operation.

[CITATION LIST]

[PATENT LITERATURE]

Patent Literature 1: Jpn. Pat. Appln. KOKAI Publication No. 2016-145795

SUMMARY

[TECHNICAL PROBLEM]

For example, Patent Literature 1 discloses a battery energy storage system including a lithium ion battery (LIB) and a power conditioning system (PCS) having a DC-AC conversion function and a step-up/step-down function. For LIBs, a method for estimating a degradation state by estimating energy efficiency has been proposed.

However, there is no technique for estimating a degradation state of entire battery energy storage system including the DC-AC converter such as the PCS in the conventional technique including Patent Literature 1. Therefore, in the conventional technique, the above-described degradation diagnosis cannot be performed practically with high accuracy.

Therefore, an object of the present invention is to provide a degradation state estimation apparatus and a degradation state estimation method that enable estimation of a degradation state of the entire battery energy storage system including a secondary battery and a DC-AC converter, and a battery energy storage system operation optimization method.

[SOLUTION TO PROBLEM]

To achieve the object, a degradation state estimation apparatus according to an embodiment of the present invention estimates a degradation state of a battery energy storage system including a secondary battery and a DC-AC converter. The apparatus includes an estimation arithmetic processing unit that estimates an open circuit voltage and an internal resistance with respect to a charging rate of the secondary battery based on a charge-discharge voltage and a charge-discharge current of the secondary battery, and input-output power of the DC-AC converter, estimates efficiency of the DC-AC converter and power consumption of an auxiliary device of the DC-AC converter, and estimates charge-discharge energy efficiency with respect to the charging rate of the secondary battery and a rated input-output ratio on an AC side of the DC-AC converter based on the estimated open circuit voltage, the internal resistance, the efficiency of the DC-AC converter, and the power consumption of the auxiliary device of the DC-AC converter.

[ADVANTAGEOUS EFFECTS]

According to the present invention, it is possible to estimate the degradation state of the entire battery energy storage system including the secondary battery and the DC-AC converter.

BRIEF DESCRIPTION OF THE DRAWINGS

FIG. 1 is a diagram illustrating an example of a configuration of a battery energy storage system according to an embodiment.
FIG. 2 is a diagram illustrating an example of a configuration of a degradation state estimation apparatus 6.
FIG. 3 is a diagram illustrating an example of specifications of a LIB module 3 in FIG. 2.
FIG. 4 is a diagram conceptually illustrating a corrected approximate curve of an open circuit voltage.
FIG. 5 is a diagram conceptually illustrating an equivalent circuit of a lithium ion battery.
FIG. 6 is a diagram illustrating an estimation error of an analysis result obtained using a Kalman filter.
FIG. 7 is a diagram illustrating an example of a Gaussian function.
FIG. 8 is a conceptual diagram illustrating an example of a model used for estimation of an efficiency curve of a PCS, and the like.
FIG. 9 is a graph illustrating a simulation operation pattern of power input and output on an AC side of the PCS of a BESS used in verification.
FIG. 10 is a graph illustrating a histogram of the power input and output on the AC side of the PCS.
FIG. 11 is a graph illustrating a result indicating variation for each predetermined elapsed time with respect to profiles of an open circuit voltage and an internal resistance learned and estimated by BT-MGFFD.
FIG. 12 is a graph illustrating variation of an estimation error of a charge-discharge voltage with respect to an elapsed time.
FIG. 13 is a graph illustrating a result of obtaining the efficiency curve of the PCS and variation of an estimation value of power consumption of an auxiliary device of the PCS learned and estimated by PCS-MGFFD from operation time series data of the LIB module and the PCS.
FIG. 14 is a graph illustrating a result of estimating charge-discharge power on a DC side of the LIB module from input/output power on an AC side of the PCS.
FIG. 15 is a graph illustrating a charging rate of the LIB, and an estimated RTE of the entire BESS with respect to a rated input-output ratio on the AC side of the PCS.
FIG. 16 is a flowchart illustrating an example of an operation of the degradation state estimation apparatus 6 according to the embodiment.

EMBODIMENTS

Hereinafter, an embodiment will be described with reference to the drawings.

First, before describing the embodiment in detail, significance of estimating a degradation state of entire battery energy storage system including a secondary battery and a DC-AC converter will be described.

A lithium ion battery (LIB), which is a typical secondary battery, has a property that charge-discharge energy efficiency decreases due to degradation. This is caused by an increase in charge-discharge energy loss due to an increase in Joule heating mainly caused by an increase in internal resistance (electric resistance and polarization resistance). Here, assuming that the charge-discharge energy loss is $E_{lib,loss}$, charge-discharge current of the LIB is I, and the internal resistance is R, $E_{lib,loss}$ can be expressed by the following Formula (1).

$$E_{lib,loss} = I^2 R \qquad (1)$$

R is a parameter of the LIB that changes due to degradation and cannot be changed intentionally in operation, but I is a parameter related to charge-discharge operation control and thus can be adjusted. Therefore, it is possible to reduce $E_{lib,loss}$ by suppressing I to be low, and as a result, it is possible to improve the charge-discharge energy efficiency.

On the other hand, the BESS includes not only the LIB but also the DC-AC converter such as a power conditioning system (PCS), and interconnects the DC LIB and the AC transmission and distribution system (power system) through the DC-AC converter. Therefore, the final charge-discharge energy efficiency (RTE: Round Trip Efficiency) of the BESS in temporary storage of the VRE described at the beginning is a value obtained by multiplying the efficiency of each of the LIB and the PCS (hereinafter, a portion having a DC-AC conversion function and a step-up/step-down function in the BESS is collectively referred to as PCS). There are some cases where the energy efficiency of the BESS is treated as a single fixed value in simulation or the like, but actually, the energy efficiency changes depending on a ratio of input/output power to rated value (hereinafter referred to as "rated input-output ratio"). In addition, the RTE of the BESS is also generally treated as a single value, but as described above, since the energy efficiency of both the LIB and the PCS changes depending on input and output, it can be easily imagined that the RTE of the entire BESS varies during operation. More importantly, sensitivity of the LIB and the PCS to the energy efficiency with respect to the rated input-output ratio is opposite in positive and negative, that is, a trade-off relationship in a low input/output region, and thus grasping each energy efficiency leads to improvement of the RTE of the BESS and improvement of operation economy.

Therefore, the inventors have verified a method for estimating energy efficiency characteristics of each of the LIB and the PCS during operation of the BESS and comprehensively diagnosing the RTE of the BESS. In the present embodiment, the method for comprehensively diagnosing the RTE of the BESS is described together with a verification result.

<Configuration of battery energy storage system (BESS)>

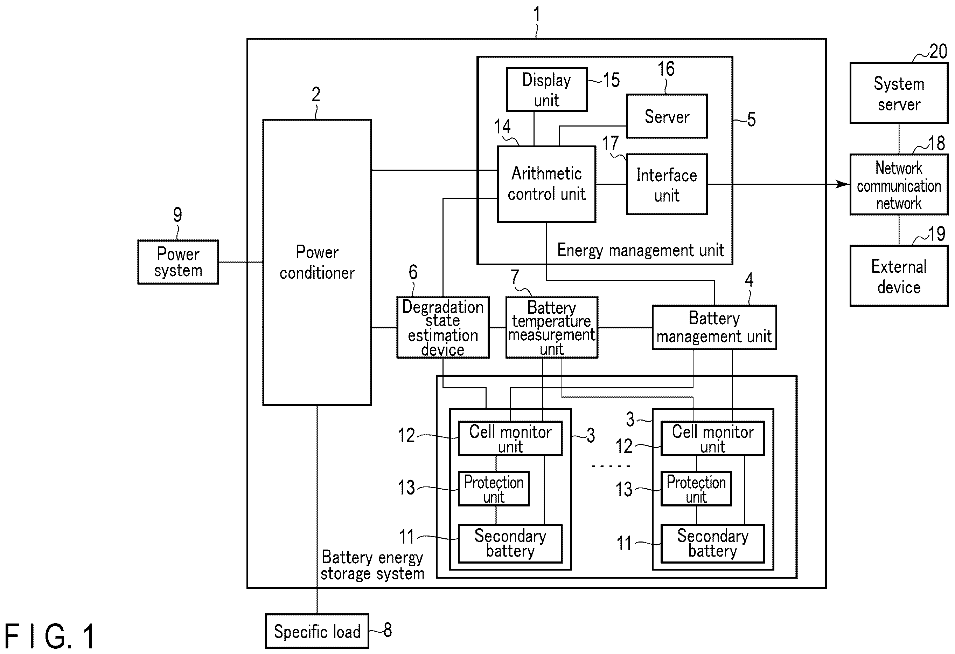

FIG. 1 is a diagram illustrating an example of a configuration of the battery energy storage system according to the embodiment.

A battery energy storage system 1 illustrated in FIG. 1 corresponds to the BESS described above. This battery energy storage system 1 mainly includes a power conditioner (power conditioning system) 2, a LIB module 3, a battery management unit (BMU) 4, an energy management unit (EMU) or an energy management system (EMS) 5, a degradation state estimation apparatus 6, and a battery temperature measurement unit 7.

The LIB module 3 corresponds to a module having the LIB described above. The power conditioner 2 corresponds to the PCS described above. The degradation state estimation apparatus 6 realizes a function of estimating the degradation state of the entire BESS including the LIB and the PCS, and a function of estimating the charge-discharge energy efficiency and the operation economy of the BESS based on a result of performed degradation state estimation.

Functions of the degradation state estimation apparatus 6 can be realized as a program to be executed by one or more computers. The degradation state estimation apparatus 6 is not necessarily provided in the battery energy storage system 1. The degradation state estimation apparatus 6 may be provided outside the battery energy storage system 1. When the degradation state estimation apparatus 6 is provided outside the battery energy storage system 1, the degradation state estimation apparatus 6 may be provided at any place on a network (cloud) capable of communicating with the battery energy storage system 1. In this case, a function of transmitting various types of information necessary for estimating the degradation state of the BESS to the degradation state estimation apparatus 6 side is provided on the battery energy storage system 1 side. A function of receiving the various types of information transmitted from the battery energy storage system 1 side is provided on the degradation state estimation apparatus 6 side. In the present embodiment, a case where the degradation state estimation apparatus 6 is provided in the battery energy storage system 1 will be described.

Details of the degradation state estimation apparatus 6 will be described later.

The power conditioner 2 is a DC-AC converter that performs DC-AC power conversion. The power conditioner 2 converts, for example, power supplied from a power system 9 of an external power company or the like, power supplied from a solar power generation system, or power supplied from the LIB module 3 to power which can be utilized by an electric drive device including a specific load 8. Furthermore, the power conditioner 2 may have a function of a charger for charging a rechargeable battery. When the specific load 8 is an electric device driven by AC power, the power conditioner 2 converts DC power supplied from the LIB module 3 into a power form of AC power. Depending on the electric device of the specific load 8, the voltage value of power may be increased. Furthermore, the power conditioner 2 can not only supply power to the specific load 8 but also release energy accumulated in the LIB module 3 to reduce consumption of the power supplied from the power system 9, when the consumption of the power supplied from the power system 9 is maximum. In this case, when power demand decreases at midnight or the like, the LIB module 3 after discharge can be fully charged through the power conditioner 2.

The specific load 8 to which the power is supplied by the battery energy storage system 1 is assumed to be a device to which the power is to be supplied when power supply from the power system 9 is stopped (for example, at the time of power outage), and is for example, an electronic device such as a computer, or a communication device, and power supply for power supply backup is performed for the specific load 8.

The LIB module 3 includes a secondary battery (rechargeable battery) 11 that outputs a DC current and voltage, a cell monitor unit (CMU) 12, and a protection unit 13. The number of the LIB modules 3 is appropriately set according to design related to an amount of power supplied to a specific load or the like, and when a large-capacity secondary battery is formed, a plurality of the LIB modules 3 may be electrically connected to form an aggregate, that is, a battery pack. Further, in the present embodiment, a lithium ion battery is described as an example of the secondary battery, but the present embodiment is not limited to this. Similarly to the lithium ion battery, the present embodiment can be easily applied to a battery with a different configuration as long as the battery has a low memory effect and good self-discharge characteristics. For example, the present embodiment can also be applied to a nanowire battery or the like improved from the lithium ion battery.

The secondary battery 11 of the present embodiment is not limited with respect to not only a battery internal material (an electrode material or the like) and a cell structure, but also a form of an exterior material, and may be a cylindrical canister type, a rectangular canister type, a laminate type, or the like. As a connection form of the secondary battery 11 constituting the LIB module 3, a known connection form such as a single battery, a series assembled battery, or a parallel assembled battery can be applied.

The battery temperature measurement unit 7 measures the temperature by a temperature sensor (not illustrated) disposed in contact with each of the secondary batteries 11. An ambient temperature, at which the lithium ion battery can be used, in an apparatus is in a range of about 5°C to 40°C; however, if necessary, a battery temperature adjustment mechanism can be provided in the apparatus, depending on an environment of installation (cold region or tropical region). The battery temperature adjustment mechanism includes a fan and a heater for performing temperature adjustment within a range (about 5°C to 40°C) in which the above-described secondary battery 11 is usable so that battery performance is not lowered when an upper limit or a lower limit of a preset temperature range is exceeded based on a temperature measured by the battery temperature measurement unit 7. Needless to say, when the temperature range in which the secondary battery 11 is usable increases due to future battery improvement, the battery temperature adjustment mechanism can adapt to the entire temperature range.

The cell monitor unit 12 has a function of continuously measuring an output voltage, a current, and a temperature of each of the secondary batteries 11 of a single battery (or a single cell) and transmitting a measurement result to the battery management unit 4. The cell monitor unit 12 measures a charge-discharge voltage every prescribed period of time during charge-discharge processing for estimating a charge-discharge curve in accordance with control of an arithmetic control unit 14 to be described later.

Furthermore, the cell monitor unit 12 has a function of transmitting the output voltage, the current, and the temperature acquired from the secondary battery 11 to the battery management unit 4 as monitor information.

The battery management unit 4 has a function of determining occurrence of abnormality such as over-charge, over-discharge, and temperature rise based on the received monitor information, and controlling the protection unit 13 to stop charge or output (discharge) to the secondary battery 11, thereby preventing over-charge and over-discharge. Note that when urgent abnormality occurs due to a failure or the like of the secondary battery 11, the protection unit 13 stops charge or output (discharge) for the secondary battery 11 by electrical shutoff. Furthermore, the protection unit 13 may have a function of avoiding danger by notifying the battery management unit 4 of the abnormality. The abnormality occurrence determination function may be provided in either the cell monitor unit 12 on the LIB module 3 side or the battery management unit 4 on the battery energy storage system 1 side, or may be provided in both the cell monitor unit 12 and the battery management unit 4 to improve safety by double determination. In the double determination, an order of determination is determined in advance, and for example, the cell monitor unit 12 first determines the occurrence of the abnormality and then the battery management unit 4 determines the occurrence of the abnormality a second time. As a determination procedure at this time, normally, the protection unit 13 executes a protection operation when one of two determination units determines that the abnormality has occurred. Note that, although depending on the design concept, it is also possible to perform the protection operation by the protection unit 13 only when both of the determination units determine that the abnormality has occurred, and issue a warning when only one of them determines that the abnormality has occurred.

Furthermore, the battery management unit 4 has a function of centrally aggregating the monitor information transmitted from the cell monitor units 12 of the LIB modules 3 and transmitting the monitor information to the energy management unit 5 at an upper level. The energy management unit 5 instructs the power conditioner 2 to charge and discharge the LIB module 3 based on the monitor information. The power conditioner 2 controls charging and discharging of the LIB module 3 according to the instruction.

The energy management unit 5 includes the arithmetic control unit 14, a display unit 15, a server 16, and an interface unit 17.

The arithmetic control unit 14 has a function equivalent to that of an arithmetic processing unit or the like of the computer, and instructs the battery management unit 4 or the power conditioner 2 to charge and discharge the LIB module 3. In addition, a charge upper limit voltage value and a discharge lower limit voltage value are set in advance for each of the LIB modules 3, and the arithmetic control unit 14 provides an instruction to stop charging or stop discharging to the battery management unit 4 or the power conditioner 2 based on the monitor information transmitted from the battery management unit 4.

The display unit 15 includes, for example, a liquid crystal display unit, and displays an operation state of the battery energy storage system 1, a remaining capacity of the LIB module 3 (secondary battery 11), and the like, and warning matters under the control of the arithmetic control unit 14. Further, the display unit 15 may employ a touch panel or the like to be used as an input device.

The server 16 stores as needed in an accumulating manner the latest information on the operation state of the battery energy storage system 1, the monitor information relating to the LIB module 3 or the like, information relating to the charge-discharge curve, and the like, which have been transmitted to the energy management unit 5. The interface unit 17 communicates with a centralized management system including the server or the like installed outside through a network communication network 18 such as the Internet.

<Configuration of degradation state estimation apparatus 6>

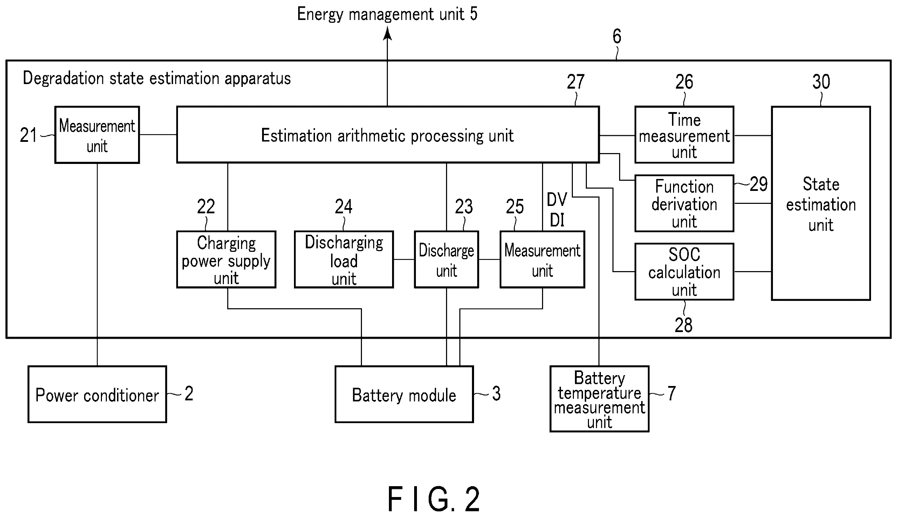

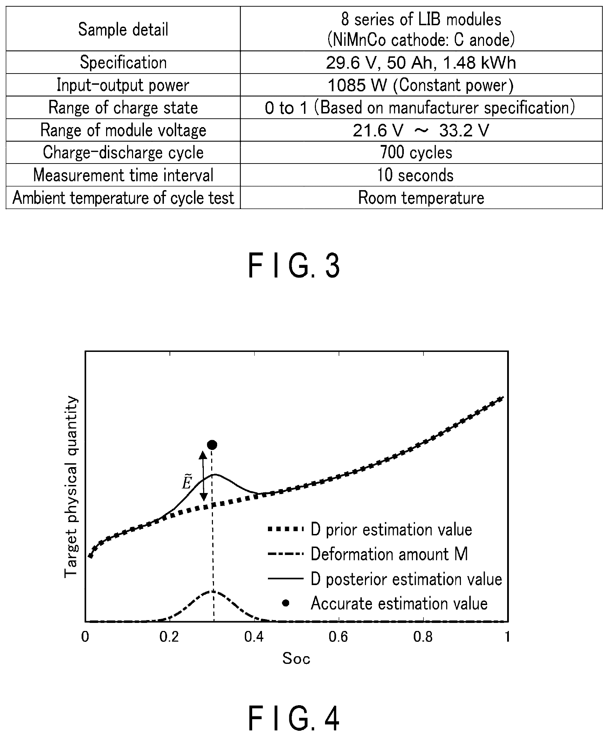

FIG. 2 is a diagram illustrating an example of a configuration of the degradation state estimation apparatus 6. FIG. 3 is a diagram illustrating an example of specifications of the LIB module 3 in FIG. 2. However, the configuration of the degradation state estimation apparatus 6 and the specifications of the LIB module 3 are not limited to the examples illustrated in FIGS. 2 and 3.

A method of comprehensively diagnosing the RTE of the BESS described at the beginning is applied to the degradation state estimation apparatus 6 (in particular, an estimation arithmetic processing unit 27) illustrated in FIG. 2. Details thereof will be described later.

The degradation state estimation apparatus 6 illustrated in FIG. 2 includes a measurement unit 21, a charging power supply unit 22, a discharge unit 23, a discharging load unit 24, a measurement unit 25, a time measurement unit 26, the estimation arithmetic processing unit 27, an SOC calculation unit 28, a function derivation unit 29, and a state estimation unit 30.

The measurement unit 21 measures a voltage and a current on the direct current (DC) side and a voltage and a current on the alternating current (AC) side of the power conditioner 2. The measurement result is transmitted to the estimation arithmetic processing unit 27.

The charging power supply unit 22 detects a charge state of the secondary battery 11, and outputs a rated DC current and voltage to the secondary battery 11 to charge the secondary battery 11 within a range up to a charge upper limit voltage of the secondary battery 11.

The charging power supply unit 22 is provided as a dedicated power supply for estimating the charge-discharge curve of the secondary battery 11, however, a battery charging power supply unit provided in the battery energy storage system or the power conditioner 2 may be used instead. In the present embodiment, the measurement unit 25 and the charging power supply unit 22 constitute a charge unit.

The discharge unit 23 includes the discharging load unit 24, electrically connects the secondary battery 11 and the discharging load unit 24 by a switch operation (not illustrated), and causes the secondary battery 11 to discharge a predetermined energy quantity (here, a constant current or a constant voltage is assumed). The discharging load unit 24 may be a resistor or an electronic load, but the load may be simulated and regenerated in the power system without providing such an exclusive load.

The measurement unit 25 measures a DC voltage and a DC current output from the LIB module 3 (secondary battery 11). As the measurement timing, the DC voltage and the DC current output from the LIB module 3 are periodically measured every time a predetermined constant time elapses. Note that as voltage and current measurements, instead of actually measuring the voltage and current, it is also possible to use the voltage value and current value included in the latest monitor information transmitted from the battery management unit 4 and stored in the server 16 of the energy management unit 5.

The time measurement unit 26 is a timer for measuring a time during which the power is charged and discharged from the LIB module 3, and measures the measurement timing.

The SOC calculation unit 28 calculates a charging rate (states of charge (SOC)) at a timing when the measurement unit 25 measures the voltage. An SOC value is a value obtained by dividing a charge current amount Qc [Ah] by a full charge capacity FCC [Ah] at that time. The SOC value of the charging rate of the present embodiment can be calculated using a Kalman filter described later. Note that the full charge capacity FCC value can be calculated by an appropriate method such as a charge-discharge differential voltage method, an AC impedance method, a discharge curve differentiation method, or optimization filtering. For example, it may be calculated by dividing a difference between accumulated charge amounts by a difference between the SOCs estimated by the Kalman filter, at two time points.

The function derivation unit 29 derives an approximate curve of an open circuit voltage function and an impedance function to be corrected, and sets the approximate curve as a prior estimation function. Various curve fitting methods can be applied to obtain the approximate curve, and the approximate curve obtained in advance can be stored and set as the prior estimation function. Further, an initial open circuit voltage function and an initial prior estimation function can also be derived.

The estimation arithmetic processing unit 27 is an arithmetic processing unit (a CPU or the like) that stores an arithmetic algorithm using a relational expression to be described later, and estimates the charge-discharge curve, an efficiency curve of the secondary battery 11, and an efficiency curve of the power conditioner 2 based on machine learning and an estimated state parameter of the secondary battery 11. The estimation arithmetic processing unit 27 is not necessarily dedicatedly provided in the degradation state estimation apparatus 6, and can cause the arithmetic control unit 14 of the energy management unit 5 to substitute a processing function.

In particular, the estimation arithmetic processing unit 27 has a function of estimating the degradation state of the BESS by estimating the open circuit voltage and the internal resistance with respect to the charging rate of the secondary battery 11 based on the charge-discharge voltage and the charge-discharge current of the secondary battery 11 of each LIB module 3, and the input-output power of the DC-AC converter, estimating the efficiency of the power conditioner 2 and power consumption of an auxiliary device of the power conditioner 2, and estimating the charging rate of the secondary battery 11, and the charge-discharge energy efficiency (RTE) with respect to the rated input-output ratio on an AC side of the power conditioner 2 based on the estimated open circuit voltage, the internal resistance, the efficiency of the DC-AC converter, and power consumption of an auxiliary device of the DC-AC converter. Furthermore, the estimation arithmetic processing unit 27 has a function of estimating the charge-discharge energy efficiency and the operation economy of the BESS based on the result of the performed degradation state estimation.

The state estimation unit 30 can estimate state parameters including the charging rate, the open circuit voltage, and the internal resistance (internal impedance) of the secondary battery 11 using a Kalman filter based on an electrochemical model, in the present embodiment, an extended Kalman filter that supports nonlinearity.

Technology described in the present embodiment can be applied to online estimation using network communication between an external device 19, a system server 20 that manages the plurality of other battery energy storage systems 1, and the like through the network communication network 18 such as the Internet. Note that in FIG. 1, one battery energy storage system 1 is representatively illustrated for easy understanding of description, but the battery energy storage system 1 is not limited to one.

(Overview of estimation by use of Kalman filter)

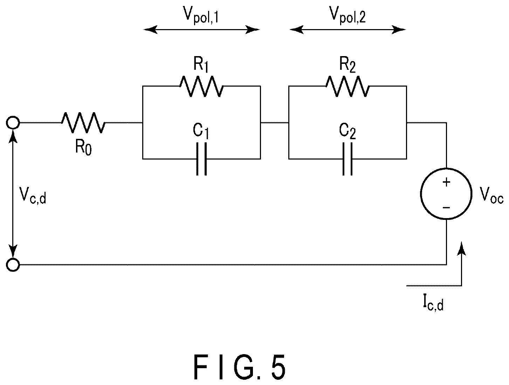

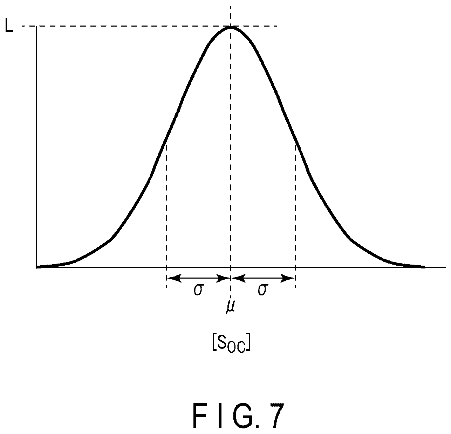

The inventors have studied estimation of the charge-discharge curve used for degradation diagnosis in a charge-discharge cycle of the lithium ion battery using the Kalman filter and a Gaussian function, and FIG. 4 is a diagram conceptually illustrating a corrected approximate curve of the open circuit voltage. FIG. 5 is a diagram conceptually illustrating an equivalent circuit of the lithium ion battery. FIG. 7 is a diagram illustrating an example of the Gaussian function.

Here, as an example, an example of a case where charging and discharging are performed in a plurality of LIB modules connected in series and time series data thereof are acquired will be described. Note that in the case of performing degradation diagnosis and state estimation, a cycle test using a single battery of a small lithium ion battery is generally adopted, but here, a LIB module including a large single battery of 50 Ah was regarded as a battery pack (an aggregate) and the test was performed. Further, during a charge-discharge cycle test, a constant power mode was employed to simulate a situation of charging and discharging by the power conditioner 2. An atmospheric temperature in the cycle test is preferably room temperature, but since unavoidable resistance heat generation occurs during charging and discharging, a module temperature was set to a range of about 20°C to 30°C.

In addition, here, a modified Gaussian free-form deformation (MGFFD) method was applied to estimate the open circuit voltage and the internal impedance. The MGFFD is known as an effective method for estimating an open circuit voltage curve with respect to the charging rate of the LIB. In the MGFFD, the open circuit voltage curve with respect to the charging rate of the LIB is deformed little by little in a direction perpendicular to an axis of the charging rate by directly adding the Gaussian function to the open circuit voltage curve, and an error is gradually reduced.

In FIG. 4, a D prior estimation value represents a prior estimation value of the open circuit voltage by graph learning. A deformation amount M represents the Gaussian function. A D posterior estimation value represents a posterior estimation value of the open circuit voltage estimated by the Kalman filter. An accurate estimation value represents the open circuit voltage estimated from the time series data at a charging rate $S_{oc,0}$ of the LIB at the time of performing correction.

As shown in FIG. 4, deformation of the open circuit voltage and the internal impedance in the lithium ion battery is performed by addition of a Gaussian function with adjusted height. That is, a value obtained by multiplying an error (estimation error) between a prior estimation value (scalar) at the point of a current charging rate SOC and a posterior estimation value (scalar) currently estimated by the Kalman filter by a learning rate L is set as the height of the Gaussian function, and added to a prior estimation value (vector) of graph learning. A function of a graph deformed in this way is a posterior estimation value (vector) of graph learning.

Next, an error index $I_{maer}$ is defined as an average absolute error rate by the following equation (2).

$$I_{maer} = \frac{1}{700} \sum_{i=1}^{700} \left| \frac{\widetilde{W}_{c,d,i}}{W_{c,d,i}} \right| \qquad (2)$$

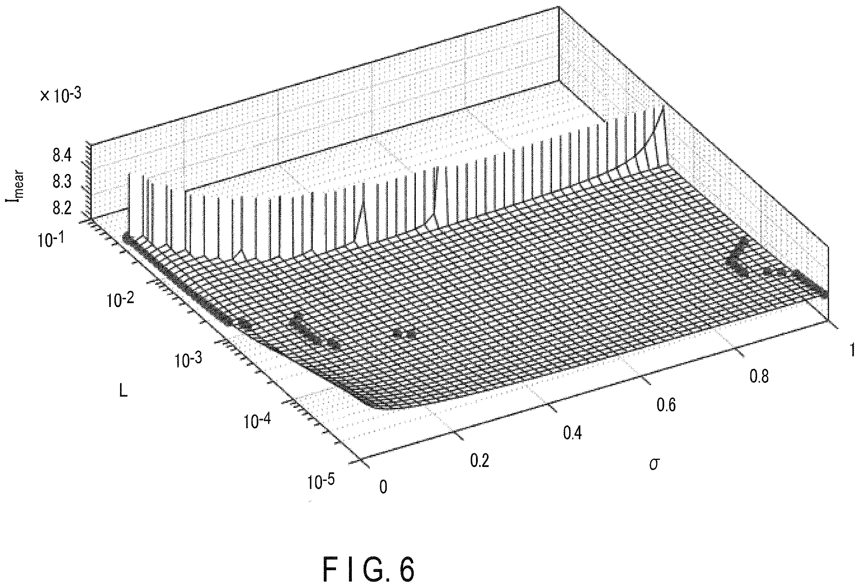

Here, since a combination condition of the learning rate L and a rough range of a correction width σ affects accuracy of charge-discharge energy estimation, a relationship between these conditions and an index of the estimation error was analyzed. In this analysis, an actual initial $V_{oc}(S_{oc})$ is adopted as a reference for $C_k$ of the Kalman filter at a start of a first cycle. This result is as illustrated in FIG. 6. FIG. 6 is a diagram illustrating a relationship between a condition combination of the learning rate L and a rough correction width σ and the error index $I_{maer}$. Each of dots is a point of best accuracy in an entire learning rate L.

From the result illustrated in FIG. 6, it has been found that an estimation process diverges in most cases when the learning rate L satisfies $L > 10^{-2}$, and approaches convergence when the correction width σ is reduced. This is because the learning rate L and the correction width σ having large values are affected by an input of E~ for excessive graph deformation. In addition, it was found that a tendency of an optimum correction width σ changed at boundaries when the learning rate L is $L = 10^{-3.8}$ and $L = 10^{-3.2}$.

<Method for comprehensively diagnosing RTE of BESS>

As mentioned at the beginning, the inventors have verified a method for estimating the energy efficiency characteristics of each of the LIB and the PCS during the operation of the BESS and comprehensively diagnosing the RTE of the BESS. Hereinafter, a specific method and a verification result thereof will be described. The method described here is applied to the function of the estimation arithmetic processing unit 27 in the degradation state estimation apparatus 6.

In this verification, the BESS was constructed using the actual PCS and LIB module, and subjected to an experiment. In a BESS installation area, an environmental temperature was controlled at $23\pm5°C$, and the voltage, the current, and the charging rate of the LIB module (DC side) were measured by a battery management system (BMS) installed in the module. The voltage and the current on the alternating current (AC) side of the PCS were measured by a clamp type power logger.

(Estimation of efficiency curve of LIB)

Estimating the charge-discharge energy efficiency of the LIB module requires estimating the open circuit voltage, the internal resistance, and the full charge capacity. Let the open circuit voltage be $V_{oc}$, the internal resistance be R, and the full charge capacity be $C_{fc}$. Among them, learning estimation of $V_{oc}$ and R was performed using the above-described MGFFD method. Specifically, the estimation was performed by learning characteristic profiles of $V_{oc}$ and R with respect to the charging rate $S_{oc}$. In order to distinguish from the MGFFD for the PCS to be described later, here, the MGFFD for the LIB module is referred to as BT-MGFFD.

In the BT-MGFFD, a charge-discharge voltage estimation value V^ is calculated from an estimated open circuit voltage $V^{\wedge}_{oc}$ and an estimated internal resistance R^ by the following equation (3), and an estimation error $V^{\sim}_{c,d} = V_{c,d} - V^{\wedge}_{c,d}$ with respect to an actually measured value $V_{c,d}$ of the charge-discharge voltage is obtained. Then, $V^{\sim}_{oc}$ and R~ are calculated from $V^{\sim}_{c,d}$ on an assumption that this estimation error occurs with half contribution degree from each of the estimated errors $V^{\sim}_{oc}$ and R- of the open circuit voltage and the internal resistance. Note that the charge-discharge current I is defined as positive during charge and negative during discharge.

$$V_{c,d} = \left( \hat{V}_{oc} + \tilde{V}_{oc} \right) + \left( \hat{R} + \tilde{R} \right) I$$

$$\frac{1}{2} \tilde{V}_{c,d} = \tilde{V}_{oc} = \tilde{R} I \qquad (3)$$

$V_{oc}$ and R are treated as vectors corresponding to a discrete value vector $S_{oc} = [0.01, 0.02, ..., 0.99]$ of the charging rate, and the prior estimation of these vectors is D^-, the posterior estimation is D^, and a correction amount at that time is $M = [M_1, M_2, ... M_{99}]$. M is defined as a Gaussian function of variance $\sigma_{lib}^2$ having a height obtained by multiplying the prior estimation error $V^{\sim}_{oc}-(S_{oc,0})$ or $R\sim-(S_{oc,0})$ in the charging rate $S_{oc,0}$ of an estimation target LIB at the time of correction by a learning rate $L_{lib}$. That is, when a target estimation error is $D\sim-(S_{oc,0})$, the following equation (4) can be expressed.

$$\hat{D} = \hat{D}^- + M$$

$$M = \begin{bmatrix} M_1 \\ \vdots \\ M_l \\ \vdots \\ M_{101} \end{bmatrix}^T , (1 \leq l, 99, l \in \mathbb{R}^+) \tag{4}$$

$$M_l = \tilde{D}^-(S_{oc,0})L_{lib}\left[-\frac{\left\{10^{-2}l - S_{oc,0}\right\}^2}{2\sigma_{lib}}\right]$$

In the case of this correction, that is, for example, $V_{oc}$, learning of the BT-MGFFD proceeds by sequentially and continuously performing the processing described in FIG. 4 using charge-discharge time series data.

Similarly, for R, the BT-MGFFD was performed based on a relationship of the equation (3) from $\tilde{V}_{c,d}$, and learning of the profile was advanced. Here, a learning parameter of the BT-MGFFD was set to $L_{lib} = \sigma_{lib} = 0.01$. In addition, since it is necessary to give initial values of the discrete value vector $V_{oc}$ and R in advance at the start of learning, with reference to correct $V_{oc}$ and R obtained by a charge-discharge test in advance, $V_{oc}$ is added with an offset, and R is set as a linear discrete value vector that deviates from a correct value, thereby setting the initial values including an error.

Here, as the $C_{fc}$, a rated capacity of 40 Ah indicated by a LIB module manufacturer was used as a fixed value. Note that when it is necessary to estimate the $C_{fc}$, the $C_{fc}$ may be calculated, for example, from cumulative charge-discharge electricity quantity $\Delta Q_{c,d}$ and a difference $\Delta S_{oc}$ of the states of charge (SOC) in the time series data between two points by the following equation (5).

$$C_{fc} = \frac{\Delta Q_{c,d}}{\Delta S_{oc}} \tag{5}$$

(Estimation of efficiency curve of PCS)

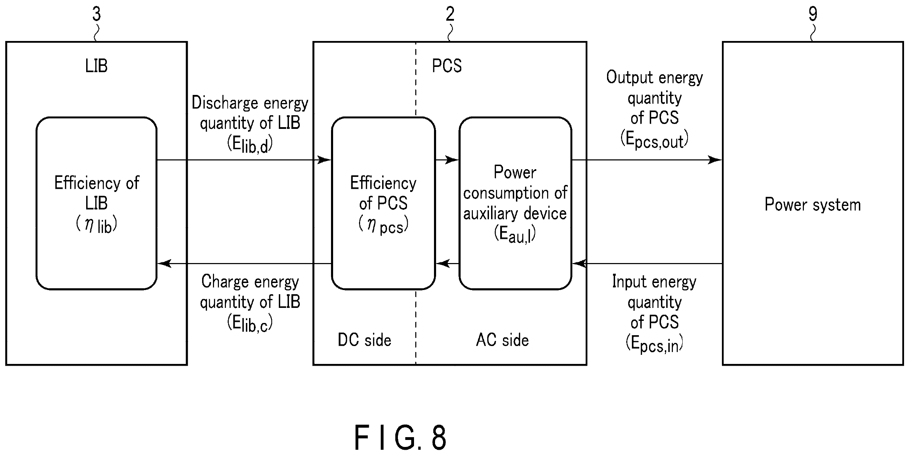

The efficiency curve of the PCS was estimated based on the model illustrated in FIG. 8 in consideration of power consumption of the auxiliary device of the PCS.

FIG. 8 is a conceptual diagram illustrating an example of a model used for estimation of the efficiency curve of the PCS, and the like.

FIG. 8 illustrates a relationship among the LIB module 3, the power conditioner 2, and the power system 9 described above. The LIB corresponds to the LIB module 3, and the PCS corresponds to the power conditioner 2. A charge energy quantity of the LIB is represented by $E_{lib,c}$, and a discharge energy quantity of the LIB is represented by $E_{lib,d}$. In addition, an input energy quantity (on the AC side) of the PCS is represented by $E_{pcs,in}$, and an output energy quantity (on the AC side) of the PCS is represented by $E_{pcs,out}$.

The estimation of the efficiency curve of the PCS was performed in the same manner as in the BT-MGFFD method described above by defining efficiency $n_{pcs}$ of the PCS as a vector $\eta_{pes}(R_{typ})$ corresponding to the discrete value vector $R_{typ}=[0, 0.01,..., 1]$ of the rated input-output ratio. Here, in order to distinguish from the BT-MGFFD described above, the MGFFD for the PCS is referred to as the PCS-MGFFD.

In the PCS-MGFFD, in consideration of power consumption $E_{au,l}$ of the auxiliary device of the PCS, the model is considered separately for charging and discharging, and it is assumed that the estimation error $\tilde{E}_{lib,c} = E_{lib,c} - \hat{E}_{lib,c}$ of the charge energy quantity of the LIB or the estimation error $\tilde{E}_{pcs,out} = E_{pcs,out} - \hat{E}_{pcs,out}$ of the output energy quantity of the PCS occurs with half contribution degree from each of the estimation errors $\eta_{pcs}$ and $\tilde{E}_{au,1}$. That is, in the case of charging, assuming that the input energy quantity of the PCS is $E_{pcs,in}$ and the charge energy quantity of the LIB is $E_{lib,c}$, focusing on the charge energy quantity of the LIB, it is assumed that a relationship of the following equation (6) is established.

$$\hat{E}_{lib,c} = (E_{pcs,in} - \hat{E}_{au,l})\hat{\eta}_{pcs,in}$$

$$\tilde{\eta}_{pcs} = \frac{\tilde{E}_{lib,c}}{2E_{pcs,in}} \qquad (6)$$

$$\tilde{E}_{au,l} = \frac{\tilde{E}_{lib,c}}{2\tilde{\eta}_{pcs}}$$

In the case of discharging, assuming that the output energy quantity of the PCS is $E_{pcs,out}$ and the discharge energy quantity of the LIB is $E_{lib,d}$, and focusing on the output energy quantity of the PCS, it is assumed that a relationship of the following equation (7) is established.

$$\hat{E}_{pcs,out} = E_{lib,d}\hat{\eta}_{pcs} - \hat{E}_{au,l}$$

$$\tilde{\eta}_{pcs} = \frac{\tilde{E}_{pcs,out}}{2E_{lib,d}} \qquad (7)$$

$$\tilde{E}_{au,l} = \frac{\tilde{E}_{pcs,out}}{2}$$

Based on the formulas (6) and (7), when the rated input-output ratio $R_{typ,0}$ on the AC side of an estimation target PCS at the time of performing correction, that is, a rated power of the PCS is $P_{pcs}$, learning by the PCS-MGFFD is advanced in the same method as the example of the equation (4) and FIG. 2 by adding the Gaussian function centered on $R_{pcs}$ such that $R_{typ,0} = P_{pcs,in}/P_{pcs}$ at the time of charging and $R_{typ,0} = P_{pcs,out}/P_{pcs}$ at the time of discharging. Learning parameters of the PCS-MGFFD are a learning rate $L_{pcs}$ and variance $\sigma_{pcs}^2$, and $L_{pcs} = 0.01$ and $\sigma_{pcs} = 0.05$, and are handled similarly to $L_{lib}$ and $\sigma_{lib}$ of the equation (4). In addition, initial values of $\eta_{pcs}(R_{typ})$ and $E_{au,l}$ [W] are given, for example, as values different from true values of actual PCS characteristics as follows.

$$\eta_{pcs}(R_{typ}) = R_{typ}^{0.02}$$

$$E_{au,l} = 50 \qquad (8)$$

(simulation operation pattern of BESS)

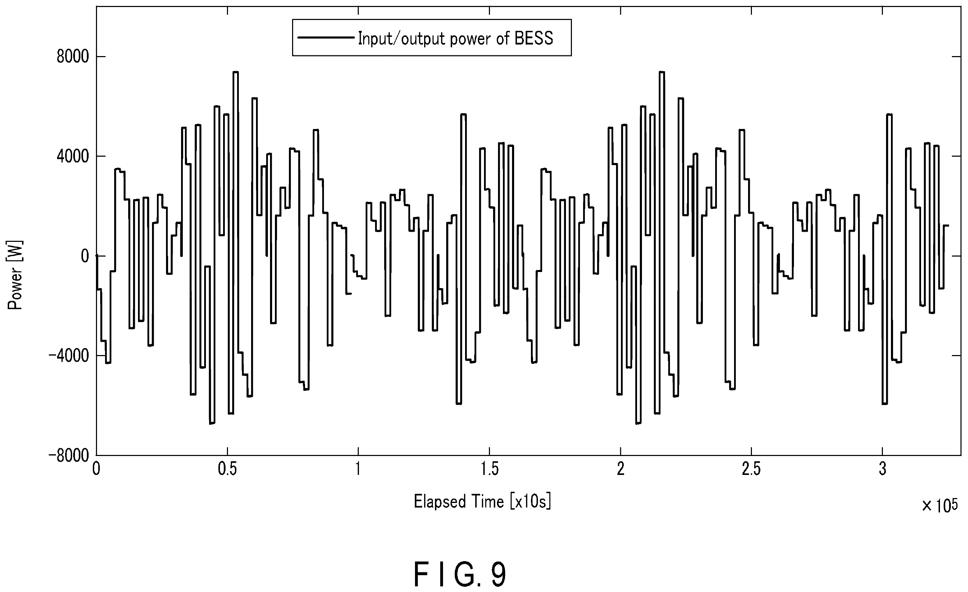

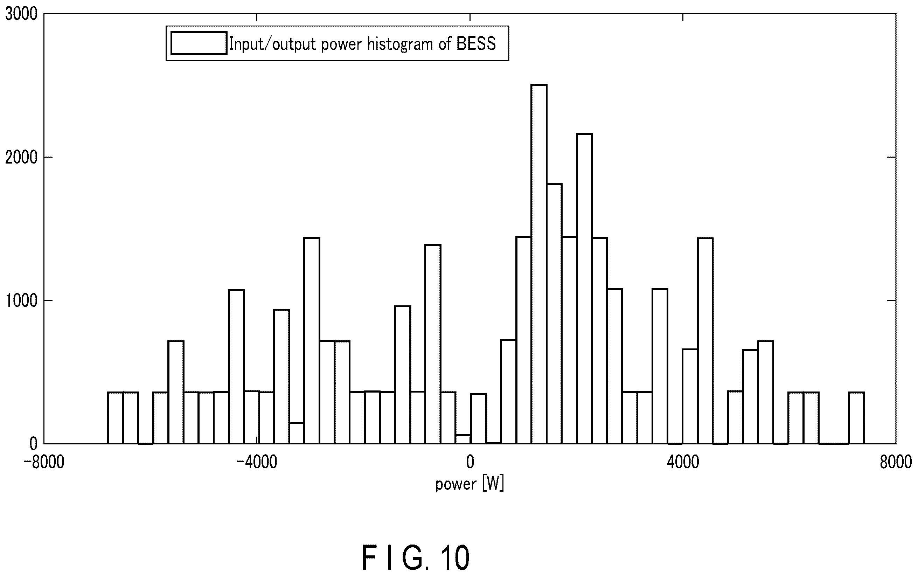

A simulation operation pattern (325,170 seconds in total) of power input and output on the AC side of the PCS of the BESS used in the verification is illustrated in a graph of FIG. 9. A horizontal axis of the graph represents an elapsed time [$\times 10$ s], and a vertical axis represents a power value [W]. The power value on the vertical axis represents charging as positive and discharging as negative, and the time series data was sampled every 10 s. The operation of the BESS was performed within a range of "$0.1 \leq S_{oc} \leq 0.9$". A histogram of the power input and output on the AC side of the PCS is illustrated in a graph of FIG. 10. The horizontal axis of the graph represents the power value [W], and the vertical axis represents the number of occurrences.

<Results and discussion>

(Estimation of open circuit voltage and internal resistance of LIB)

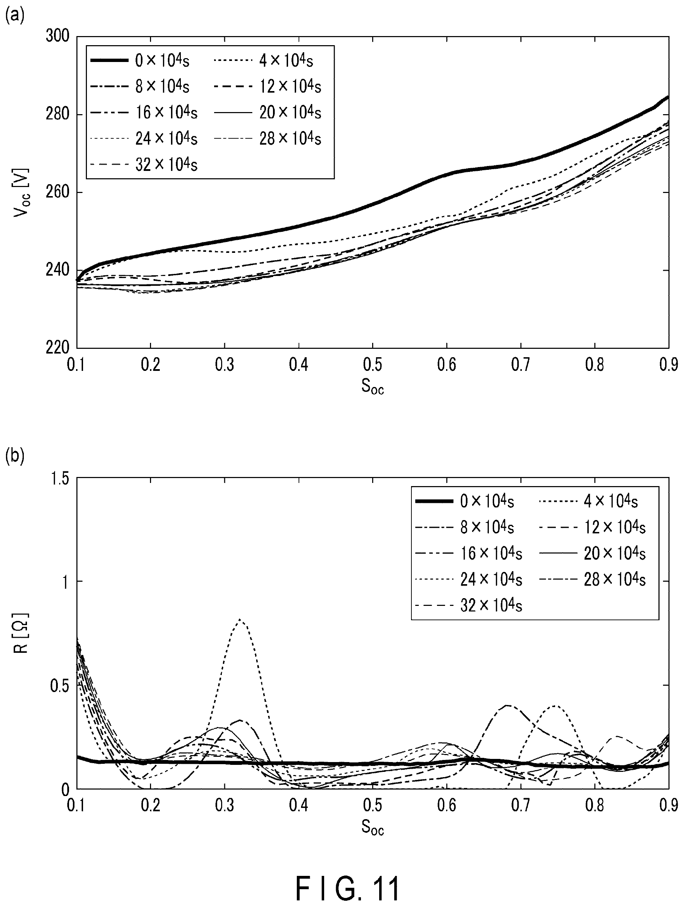

Graphs of FIGS. 11(a) and 11(b) illustrate variation for each elapsed time ($4 \times 10^4$ seconds) with respect to profiles of the open circuit voltage $V_{oc}$ and the internal resistance R learned and estimated by the BT-MGFFD using operation time series data (voltage and current) of the LIB based on the simulation operation pattern illustrated in FIG. 9. In the graph of FIG. 11(a), the horizontal axis represents charging $S_{oc}$, and the vertical axis represents the open circuit voltage $V_{oc}$. In the graph of FIG. 11(b), the horizontal axis represents charging $S_{oc}$ [V], and the vertical axis represents the internal resistance R [$\Omega$]. A difference in line type in each graph indicates a difference in elapsed time.
FIGS. 11 (a) and (b) illustrate a state in which the learning by the MGFFD converges at an end of the simulation operation and the profile hardly changes as time elapses.

(Estimation of charge-discharge voltage of LIB module)

Based on the current value of the charge-discharge time series data of the LIB module based on the simulation operation pattern illustrated in FIG. 9 and the profiles of $V_{oc}$ and R sequentially subjected to learning estimation by the BT-MGFFD, the charge-discharge voltage $V_{c,d}$ of the LIB module was sequentially estimated based on the following equation (9).

$$\hat{V}_{c,d} = \hat{V}_{oc} + I\hat{R} \qquad (9)$$

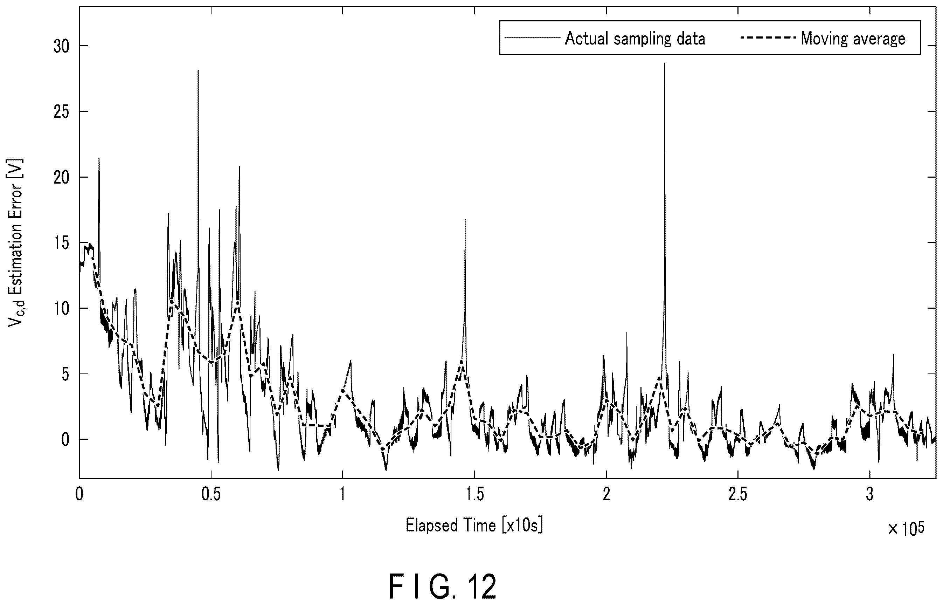

Variation for each elapsed time of an estimation error of the charge-discharge voltage $V_{c,d}$ with respect to the elapsed time is illustrated in a graph of FIG. 12. The horizontal axis of the graph represents the elapsed time [$\times 10$ s], and the vertical axis represents the estimation error [V] of the charge-discharge voltage $V_{c,d}$. A solid line in the graph indicates actually measured values of sampling data, and a broken line indicates a moving average thereof.

The moving average of the estimation error decreased over time, and at the end, it was shown that the error remains at a maximum of about 3 V with respect to a rated voltage of 248.4 V of the LIB module.

(Estimation of efficiency curve of PCS)

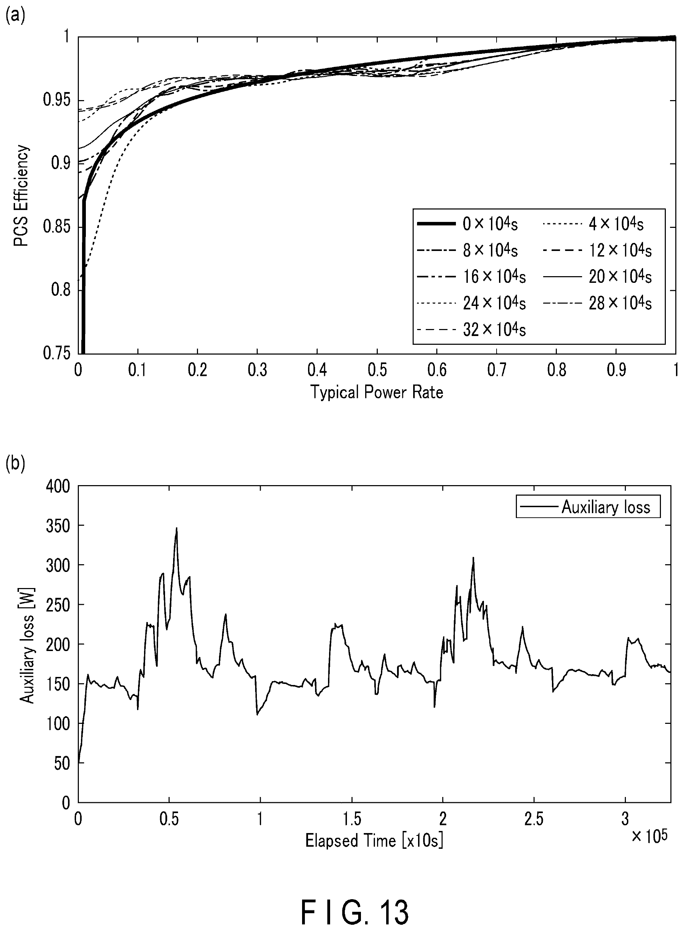

Based on the simulation operation pattern of the BESS illustrated in FIG. 9, the efficiency curve of the PCS learned and estimated by the PCS-MGFFD from the operation time series data of the LIB module and the PCS, and the variation of the power consumption estimation value of the auxiliary device of the PCS are obtained, and the results are respectively illustrated in graphs of FIGS. 13(a) and 13(b). In the graph of FIG. 13(a), the horizontal axis represents the rated input-output ratio on the AC side of the PCS, and the vertical axis represents the efficiency of the PCS. A difference in line type in the graph of FIG. 13(a) indicates a difference in the elapsed time. That is, the graph of FIG. 13(a) shows variation of the efficiency of the PCS for each elapsed time ($4 \times 10^4$ seconds). In the graph of FIG. 13(b), the horizontal axis represents the elapsed time [$\times 10$ s], and the vertical axis represents the power consumption [W] of the auxiliary device.

FIG. 13(a) showed that learning results of the efficiency curve of the PCS converged at the end of the simulation operation. FIG. 13(b) showed that the estimation value of the power consumption of the auxiliary device converged with a constant width.

(Estimation of LIB module input/output from PCS input/output)

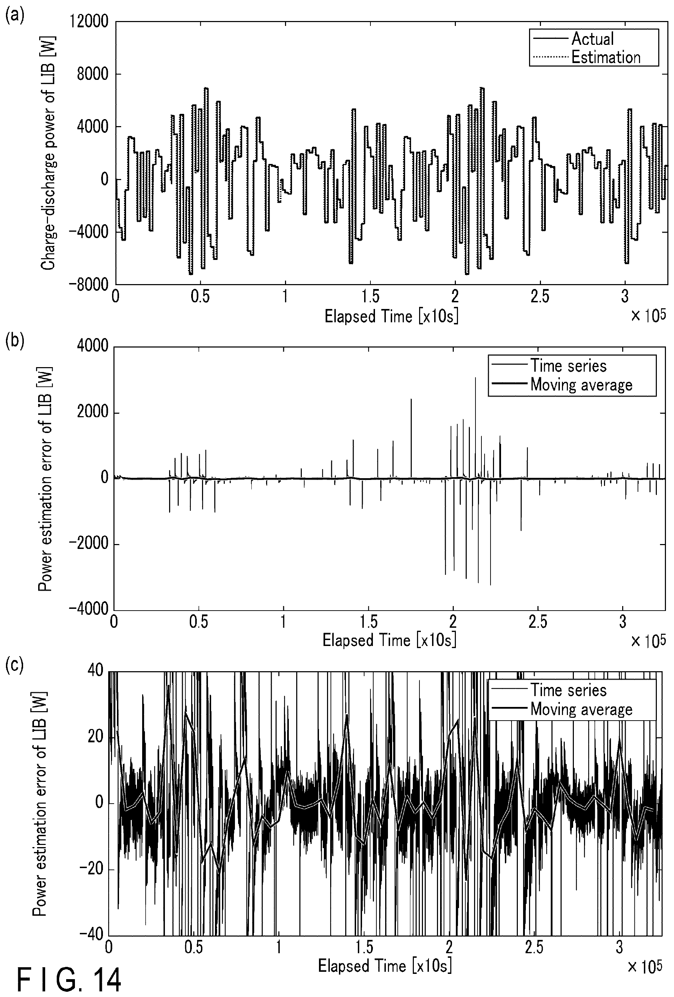

Results of estimating charge-discharge power on the DC side of the LIB module from the input-output power on the AC side of the PCS based on learning results of the BT-MGFFD and the PCS-MGFFD illustrated in FIGS. 11 and 13 are illustrated in graphs of FIGS. 14(a), 14(b), and 14(c). In the graph of FIG. 14(a), the horizontal axis represents the elapsed time [$\times 10$ s], and the vertical axis represents the charge-discharge power [W] on the DC side of the LIB module. A solid line in the graph of FIG. 14(a) indicates actually measured values, and a broken line indicates a moving average thereof. In the graph of FIG. 14(b), the horizontal axis represents the elapsed time [$\times 10$ s], and the vertical axis represents the estimation error [W] of the charge-discharge power on the DC side of the LIB module. A solid line in the graph of FIG. 14(b) indicates actually measured values of time series data, and a broken line indicates a moving average thereof. The graph of FIG. 14(c) illustrates a part of the graph of FIG. 14(b) in an enlarged manner. The vertical axis of each graph represents the charging as positive and the discharging as negative.

In FIG. 14(b), a peak considered to be caused by a response time difference between the AC side and the DC side of the PCS is observed, but as illustrated in FIG. 14(c), the moving average converges to an error of 30 W or less, which is considered to be an acceptable level of estimation accuracy for each fixed time period.

(Development to operation efficiency improvement and economic efficiency optimization)

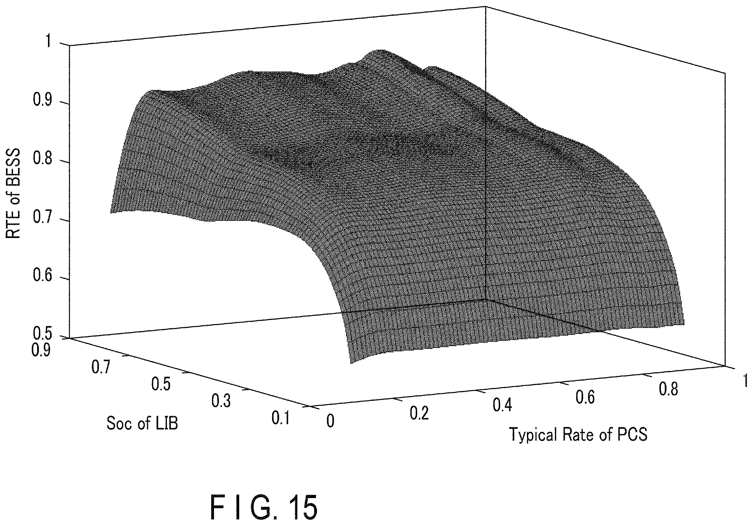

From the characteristic profiles of the open circuit voltage $V_{oc}$ and the internal resistance R of the LIB estimated by the BT-MGFFD and the PCS-MGFFD (FIG. 11), and the efficiency curve and the variation of the power consumption of the auxiliary device of the PCS (FIG. 13), it is possible to obtain the graph as illustrated in FIG. 15, that is, information of an estimated RTE of the entire BESS with respect to the charging rate $S_{oc}$ of the LIB and the rated input-output ratio on the AC side of the PCS. It is obvious that the estimated RTE varies depending on conditions such as the model of the BESS and aging of the installed LIB and PCS. Therefore, in a case where a cloud battery management system that bundles and controls a large number of BESSs by ICT is configured, it is considered that the MGFFD method described here can be an effective means for overall operation efficiency improvement and economic efficiency optimization.

<Operation of degradation state estimation apparatus>

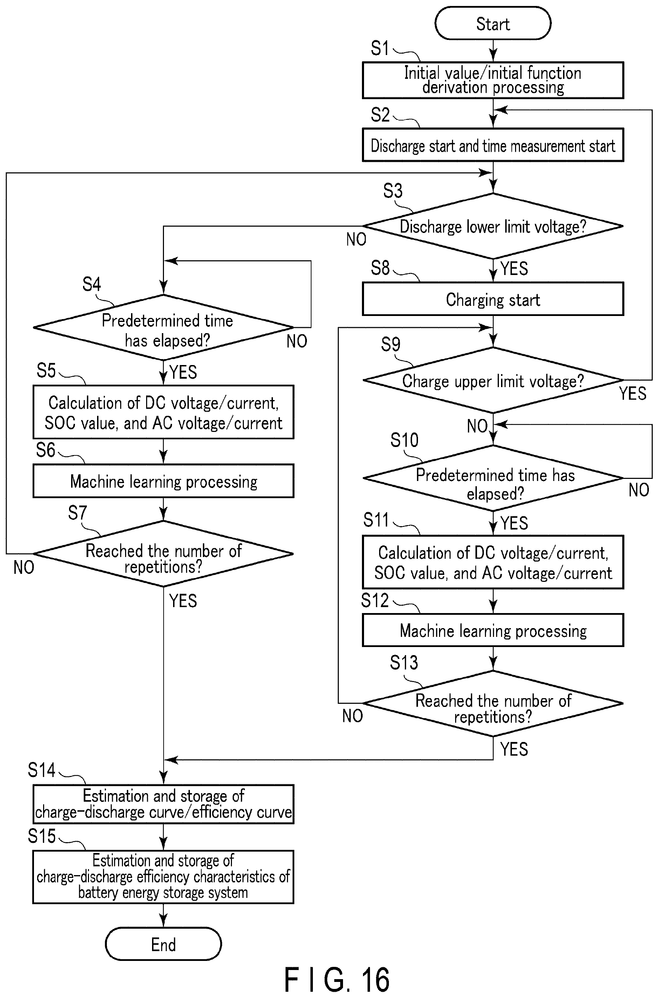

Next, an example of an operation of the degradation state estimation apparatus 6 of the present embodiment will be described with reference to a flowchart illustrated in FIG. 16.

First, initial value/initial function derivation processing is performed (step S1). Specifically, an approximate curve based on an initial open circuit voltage function $V_{oc}(S_{oc})$ and an initial internal resistance function $R(S_{oc})$ to be initially corrected is derived.

Next, the discharge unit 23 electrically connects the secondary battery 11 to the discharging load unit 24 and starts discharging, and the time measurement unit 26 starts timing (step S2).

After the discharging is started, it is determined whether the voltage has reached a discharge lower limit voltage (step S3). If it is determined in step S3 that the voltage has reached the discharge lower limit voltage (YES), the charging is started (step S8). On the other hand, if the voltage has not reached the discharge lower limit voltage (NO), the discharging is continued.

After the discharging is started, it is determined whether a prescribed time has elapsed (step S4). In the determination in step S4, the discharging is continued until the prescribed time elapses (NO), and if the prescribed time elapses (YES), the measurement unit 25 measures the discharge voltage and the charge-discharge current of the secondary battery 11, the SOC calculation unit 28 and the like calculate the DC voltage/current, the SOC value, and the AC voltage/current (step S5), and machine learning processing is performed (step S6). At this time, the correction is repeatedly performed using the Kalman filter of the state estimation unit 30 to improve accuracy of a posterior estimation approximate curve.

Next, it is determined whether the number of repeated corrections has reached a predetermined number of repetitions (step S7). In this determination, if the number of corrections has not reached the predetermined number of repetitions (NO), the process returns to step S3 to continue the discharging. When the discharging is continued, it is determined again whether the voltage has reached the discharge lower limit voltage (step S3), and if the voltage has not reached the discharge lower limit voltage (NO), processing routine of steps S3 to S7 is repeated. If it is determined in step S7 that the number of corrections has reached the predetermined number of repetitions (YES), the charge-discharge curve of the LIB module, the efficiency curve of the LIB, and the efficiency curve of the PCS are estimated using approximate curves of the open circuit voltage function and the internal resistance function, or the like (step S14). The estimated charge-discharge curve of the LIB module and the estimated efficiency curve of the PCS are temporarily stored in the server 16 of the energy management unit 5.

If it is determined in step S3 described above that the discharge lower limit voltage has been reached (YES), the charging is started (step S8). After the charging is started, it is determined whether the voltage has reached the charge upper limit voltage (step S9). If it is determined in step S9 that the charge upper limit voltage has not been reached (NO), it is determined whether a predetermined time has elapsed (step S10), and if it is determined that the charge upper limit voltage has been reached (YES), the process returns to step S2.

In the determination in step S10, after a predetermined time has elapsed (YES), the discharge voltage $V_{c,d}$ and the charge-discharge current I of the secondary battery 11 are measured by the measurement unit 25, the DC voltage/current, the SOC value, and the AC voltage/current are calculated by the SOC calculation unit 28 and the like (step S11), and the machine learning processing is performed (step S12). At this time, the correction is repeatedly performed using the Kalman filter of the state estimation unit 30 to improve accuracy of a posterior estimation approximate curve.

Next, it is determined whether the number of repeated corrections has reached a predetermined number of repetitions (step S13). If it is determined in step S13 that the predetermined number of repetitions has not been reached (NO), the process returns to step S9 to continue the charging. Here, when the charging is continued, it is determined in step S9 whether the charge upper limit voltage has been reached, and if the charge upper limit voltage has not been reached and the predetermined number of repetitions has not been reached in the determination of step S13, processing routine of steps S9 to S12 is repeated.

In the determination of step S13, if the number of repetitions has been reached (YES), the process proceeds to step S14.

Next, the estimation arithmetic processing unit 27 estimates the charge-discharge curve of the LIB module, the efficiency curve of the LIB, and the efficiency curve of the PCS by using the approximate curves of the open circuit voltage function and the internal resistance function, or the like, and stores them, for example, in the server 16 of the energy management unit 5 (step S14).

Finally, the estimation arithmetic processing unit 27 estimates charge-discharge efficiency characteristics of the battery energy storage system 1 based on the efficiency curve of the LIB and the efficiency curve of the PCS, and stores them, for example, in the server 16 of the energy management unit 5 (step S15).

The stored charge-discharge curve of the LIB module and the efficiency curve of the PCS are read from the server 16 according to a request, and can be used for other purposes in addition to display on the display unit 15.

## EP 4 769 872 A1

<Summary>

In the present embodiment, the MGFFD method was not applied only to the estimation of the open circuit voltage curve and the estimation of the internal resistance curve of the LIB module, but was further applied to the estimation of the efficiency curve and the estimation of the power consumption of the auxiliary device of the PCS. That is, a combination of the BT-MGFFD and the PCS-MGFFD was adopted. This makes it possible to accurately estimate the charge-discharge energy efficiency based on AC input/output terminals of the PCS in consideration of the charging rate of the LIB and the rated input-output ratio of the PCS. In addition, this makes it possible to estimate the RTE of the entire BESS and a final utilization rate and the operation economy in temporary storage of renewable energy, and to optimize operation of the cloud battery management system in microgrid or the like.

Note that the present invention is not limited to the above embodiments, and various modifications may be made without departing from the spirit of the invention. Furthermore, various inventions for solving the above problems are extracted by selecting or combining a plurality of disclosed constituent elements.

[REFERENCE SIGNS LIST]

| | |
|---|---|
| 1 | Battery energy storage system |
| 2 | Power conditioner (PCS) |
| 3 | LIB module |
| 4 | Battery management unit |
| 5 | Energy management unit |
| 6 | Degradation state estimation apparatus |
| 7 | Battery temperature measurement unit |
| 8 | Specific load |
| 9 | Power system |
| 11 | Secondary battery |
| 12 | Cell monitor unit |
| 13 | Protection unit |
| 14 | Arithmetic control unit |
| 15 | Display unit |
| 16 | Server |
| 17 | Interface unit |
| 18 | Network communication network |
| 19 | External device |
| 20 | System server |
| 21 | Measurement unit |
| 22 | Charging power supply unit |
| 23 | Discharge unit |
| 24 | Discharging load unit |
| 25 | Measurement unit |
| 26 | Time measurement unit |
| 27 | Estimation arithmetic processing unit |
| 28 | SOC calculation unit |
| 29 | Function derivation unit |
| 30 | State estimation unit |

**Claims**

1.  A degradation state estimation apparatus that estimates a degradation state of a battery energy storage system including a secondary battery and a DC-AC converter, the apparatus comprising:
    an estimation arithmetic processing unit that estimates an open circuit voltage and an internal resistance with respect to a charging rate of the secondary battery based on a charge-discharge voltage and a charge-discharge current of the secondary battery, and input-output power of the DC-AC converter, estimates efficiency of the DC-AC converter and power consumption of an auxiliary device of the DC-AC converter, and estimates charge-discharge energy efficiency with respect to the charging rate of the secondary battery and a rated input-output ratio on an AC side of the DC-AC converter based on the estimated open circuit voltage, the internal resistance, the efficiency of the DC-AC converter, and the power consumption of the auxiliary device of the DC-AC converter.

2. The degradation state estimation apparatus according to claim 1, wherein
the estimation arithmetic processing unit estimates a degradation state of the battery energy storage system including the secondary battery and the DC-AC converter by estimating the charge-discharge energy efficiency with respect to the charging rate of the secondary battery and the rated input-output ratio on the AC side of the DC-AC converter.

3. The degradation state estimation apparatus according to claim 1, wherein
the estimation arithmetic processing unit estimates an efficiency curve of the DC-AC converter by defining the efficiency of the DC-AC converter as a vector corresponding to a discrete value vector of a rated input-output ratio.

4. The degradation state estimation apparatus according to claim 1, further comprising
a state estimation unit that estimates a state parameter including the charging rate of the secondary battery, the open circuit voltage, and the internal resistance using a Kalman filter that supports nonlinearity.

5. The degradation state estimation apparatus according to any one of claims 1 to 4, wherein
the degradation state estimation apparatus is provided outside the battery energy storage system.

6. A degradation state estimation method for a battery energy storage system including a secondary battery and a DC-AC converter, the method comprising:
performing an estimation arithmetic processing for estimating a degradation state of the battery energy storage system by estimating an open circuit voltage with respect to a charging rate of the secondary battery, estimating an internal resistance, estimating efficiency of the DC-AC converter, estimating power consumption of an auxiliary device of the DC-AC converter, and estimating charge-discharge energy efficiency with respect to the charging rate of the secondary battery and a rated input-output ratio on an AC side of the DC-AC converter based on the estimated curve of the open circuit voltage, curve of the internal resistance, curve of the efficiency of the DC-AC converter, and history of the power consumption of the auxiliary device of the DC-AC converter.

7. The degradation state estimation method according to claim 6, wherein
the estimation arithmetic processing includes estimating a degradation state of a battery energy storage system including the secondary battery and the DC-AC converter by estimating charge-discharge energy efficiency with respect to the charging rate of the secondary battery and the rated input-output ratio on an AC side of the DC-AC converter.

8. The degradation state estimation method according to claim 6, wherein
the estimation arithmetic processing includes estimating an efficiency curve of the DC-AC converter by defining the efficiency of the DC-AC converter as a vector corresponding to a discrete value vector of a rated input-output ratio.

9. The degradation state estimation method according to claim 6, further comprising
estimating a state parameter including the charging rate of the secondary battery, the open circuit voltage, and the internal resistance using a Kalman filter that supports nonlinearity.

10. A battery energy storage system operation optimization method for estimating charge-discharge energy efficiency and operation economy of the battery energy storage system based on a result of degradation state estimation performed by the degradation state estimation apparatus according to claim 1 or the degradation state estimation method according to claim 6.

F I G. 1

Degradation state estimation apparatus

Energy management unit 5

6

30 State estimation unit

26 Time measurement unit

29 Function derivation unit

28 SOC calculation unit

27 Estimation arithmetic processing unit

7 Battery temperature measurement unit

25 Measurement unit

DV DI

23 Discharge unit

24 Discharging load unit

22 Charging power supply unit

3 Battery module

21 Measurement unit

2 Power conditioner

F I G. 2

| Sample detail | 8 series of LIB modules (NiMnCo cathode: C anode) |
|---|---|
| Specification | 29.6 V, 50 Ah, 1.48 kWh |
| Input-output power | 1085 W (Constant power) |
| Range of charge state | 0 to 1 (Based on manufacturer specification) |
| Range of module voltage | 21.6 V ～ 33.2 V |
| Charge-discharge cycle | 700 cycles |
| Measurement time interval | 10 seconds |
| Ambient temperature of cycle test | Room temperature |

F I G. 3

F I G. 4

F I G. 5

FIG.6

F I G. 7

```
                3                                    2                                          9

        ┌─────────────┐              ┌──────────────────────────────┐          ┌──────────────┐
        │     LIB     │              │            PCS               │          │              │
        │             │  Discharge energy │                         │  Output energy           │
        │  ┌───────┐  │  quantity of LIB  │  ┌──────┐   ┌─────────┐ │  quantity │              │
        │  │Efficiency│ │   (Elib,d)   │  │Efficiency│ │  Power  │ │  of PCS   │              │
        │  │   of    │ │───────────────►│  │ of PCS  │ │consumption│ │(Epcs,out) │              │
        │  │   LIB   │ │              │  │ (ηpcs)  │ │of auxiliary│ │──────────►│ Power system │
        │  │ (ηlib)  │ │              │  │         │ │  device  │ │           │              │
        │  │         │ │ Charge energy │  │         │ │ (Eau,l) │ │  Input energy           │
        │  │         │ │ quantity of LIB │  │         │ │         │ │  quantity │              │
        │  └───────┘  │◄──(Elib,c)────│  └──────┘   └─────────┘ │◄──of PCS──│              │
        │             │              │   DC side   │   AC side   │  (Epcs,in)│              │
        └─────────────┘              └──────────────────────────────┘          └──────────────┘
```

F I G. 8

Input/output power of BESS

Power [W]

Elapsed Time [x10s]

x 10⁵

F I G. 9

F I G. 10

EP 4 769 872 A1

(a)

(b)

F I G. 11

F I G. 12

EP 4 769 872 A1

(a)

(b)

F I G. 13

(a)

(b)

(c)

F I G. 14

F I G. 15

Start

S1 — Initial value/initial function derivation processing

S2 — Discharge start and time measurement start

S3 — Discharge lower limit voltage?
NO

YES

S8 — Charging start

S9 — Charge upper limit voltage?
YES

NO

S4 — Predetermined time has elapsed?
NO

YES

S5 — Calculation of DC voltage/current, SOC value, and AC voltage/current

S6 — Machine learning processing

S7 — Reached the number of repetitions?
NO

YES

S10 — Predetermined time has elapsed?
NO

YES

S11 — Calculation of DC voltage/current, SOC value, and AC voltage/current

S12 — Machine learning processing

S13 — Reached the number of repetitions?
NO

YES

S14 — Estimation and storage of charge-discharge curve/efficiency curve

S15 — Estimation and storage of charge-discharge efficiency characteristics of battery energy storage system

End

F I G. 16

## INTERNATIONAL SEARCH REPORT

| International application No. |
| --- |
| **PCT/JP2024/029792** |

| A. | CLASSIFICATION OF SUBJECT MATTER |
| --- | --- |

*H02J 7/00*(2006.01)i; *G01R 31/00*(2006.01)i; *G01R 31/382*(2019.01)i; *G01R 31/385*(2019.01)i; *G01R 31/389*(2019.01)i; *G01R 31/392*(2019.01)i; *H01M 10/48*(2006.01)i
FI: H02J7/00 Y; G01R31/392; G01R31/382; G01R31/385; G01R31/389; H01M10/48 P; G01R31/00

According to International Patent Classification (IPC) or to both national classification and IPC

| B. | FIELDS SEARCHED |
| --- | --- |

Minimum documentation searched (classification system followed by classification symbols)

H02J7/00; G01R31/00; G01R31/382; G01R31/385; G01R31/389; G01R31/392; H01M10/48

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2021-22455 A (NISSIN ELECTRIC CO., LTD.) 18 February 2021 (2021-02-18) entire text, all drawings | 1-10 |
| A | JP 2016-145795 A (DAIWA CAN CO., LTD.) 12 August 2016 (2016-08-12) entire text, all drawings | 1-10 |

☐ Further documents are listed in the continuation of Box C.    ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **24 September 2024** | **01 October 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

## INTERNATIONAL SEARCH REPORT
### Information on patent family members

International application No.

**PCT/JP2024/029792**

| Patent document cited in search report | Publication date (day/month/year) | Patent family member(s) | Publication date (day/month/year) |
|---|---|---|---|
| JP 2021-22455 A | 18 February 2021 | (Family: none) | |
| JP 2016-145795 A | 12 August 2016 | (Family: none) | |

Form PCT/ISA/210 (patent family annex) (July 2022)

**EP 4 769 872 A1**

**Patent documents cited in the description**

- JP 2016145795 A